# EUROPÄISCHE PATENTSCHRIFT

(11) **EP 0 806 493 B1**
(45) Veröffentlichungstag und Bekanntmachung des Hinweises auf die Patenterteilung: **22.08.2001**
(21) Anmeldenummer: 97107377.0
(22) Anmeldetag: 05.05.1997
(51) Int. Cl.: C23C 14/50

(54) **Vakuum-Beschichtungsanlage zum Aufdampfen von Vergütungsschichten auf optische Substrate**
Vapor deposition apparatus for coating optical substrates
Appareil de dèpôt en phase vapeur pour revêtement de substrates optiques

(30) Priorität: 10.05.1996 CH 119896
(43) Veröffentlichungstag der Anmeldung: 12.11.1997
(73) Patentinhaber: Satis Vacuum Industries Vertriebs - AG, 8700 Küsnacht (CH)
(72) Erfinder: Suter, Rudolf, 6048 Horw (CH)
(74) Vertreter: Petschner, Goetz

(56) Entgegenhaltungen:
- US-A- 3 396 696
- US-A- 3 799 110
- US-A- 4 817 559

## Beschreibung

Die vorliegende Erfindung betrifft eine Vakuum-Beschichtungsanlage zum Aufdampfen von Vergütungsschichten auf Flächen optischer Substrate, wie Kunststoff-Brillengläser, welche auf Trägermit-tel aufspannbar sind, die sich in einem evakuierbaren Rezipienten im Strahlungsbereich mindestens einer Verdampfungsquelle befinden, wobei die Trägermittel von einer Wendeträger-Vorrichtung gebildet sind, mit einer Mehrzahl, radial um eine kreisförmige Trägerplatte angeordnete Wendeträger, die je an einer, temporär um 180° verdrehbaren Drehachse abgestützt sind und je Mittel zum klemmenden Festhalten eines beidseitig zu beschichtenden Substrates oder zum Festhalten von zwei einseitig zu beschichtenden Substraten umfassen und wobei an den Drehachsen Wendemittel zum gleichzeitigen Wenden aller Wendeträger angreifen.

Eine solche Anordnung ist durch die US-A-3,396,696 bekannt, welche allerdings eine schwere, komplizierte, labile und teure Konstruktion zeigt, die ein schnelles Wenden nicht zulässt.

Durch die US-A-3,799,110 ist ferner eine Einrichtung bekannt geworden, welche als Trägermittel eine Mehrzahl sogenannte Kalotten verwendet, welche sich jeweils kuppelförmig und drehbar im oberen Teil des Rezipienten erstrecken und welche eine Mehrzahl, beispielsweise insgesamt 36 gleichmässig über die Kalottenflächen verteilte Einspannöffnungen zur Aufnahme der Substrate aufweisen. Hierbei können dann durch das Wenden jeder Kalotte eine Mehrzahl Substrate jeweils gleichzeitig gewendet werden.

Auch diese Anordnung ist eine schwere, komplizierte, labile und teure Konstruktion, die ein schnelles Wenden nicht zulässt.

Aufgabe der vorliegenden Erfindung ist es nun, eine Vakuum-Beschichtungsanlage der vorgenannten Art zu schaffen, welche gestattet, alle Substrate gleichzeitig und ohne Unterbrechung des Aufdampfstromes schnell zu wenden.

Dies wird erfindungsgemäss dadurch erreicht, dass die Wendemittel einen von der Trägerplatte umfänglich abragenden Zahnkranz umfassen, in den je ein Mitnahmezahnrad auf je einer der Drehachsen der Wendeträger eingreift, welche Mitnahmezahnräder gleichzeitig in einen weiteren, temporär von den äusseren motorischen Antriebsmitteln der Wendeträger-Vorrichtung antreibbaren, verdrehbaren Gegenzahnkranz eingreifen, zu deren gleichzeitigen raschen Verdrehung um 180° bei einer Verdrehung des Gegenzahnkranz relativ zum Zahnkranz.

Durch dieses Massnahmen ist es nunmehr möglich, jeweils innerhalb eines Bedampfungsvorganges zur Erzeugung einer Vergütungsschicht zunächst die der Verdampfungsquelle zugewendeten Flächen der auf Trägermittel aufgespannten Substrate zu bedampfen und dann, ohne Stillsetzung der Verdampfungsquelle, die Trägenmittel mit den Substraten rasch zu wenden und die nun der Verdampfungsquelle zugewendeten Flächen der Substrate ebenfalls zu bedampfen.

Beispielsweise Ausführungsformen des Erfindungsgegenstandes sind nachfolgend anhand der Zeichnung näher erläutert. Es zeigen:
- Fig. 1: im Längsschnitt in schematischer, vereinfachter Darstellung eine Vakuum-Beschichtungsanlage zum Bedampfen mehrerer optischer Substrate auf einer Wendeträger-Vorrichtung;
und
- Fig. 2: in schematischer, schaubildartiger Darstellung und in grösserem Massstab die erfindungsgemässe Wendeträger-Vorrichtung der Anlage gemäss Fig. 1.

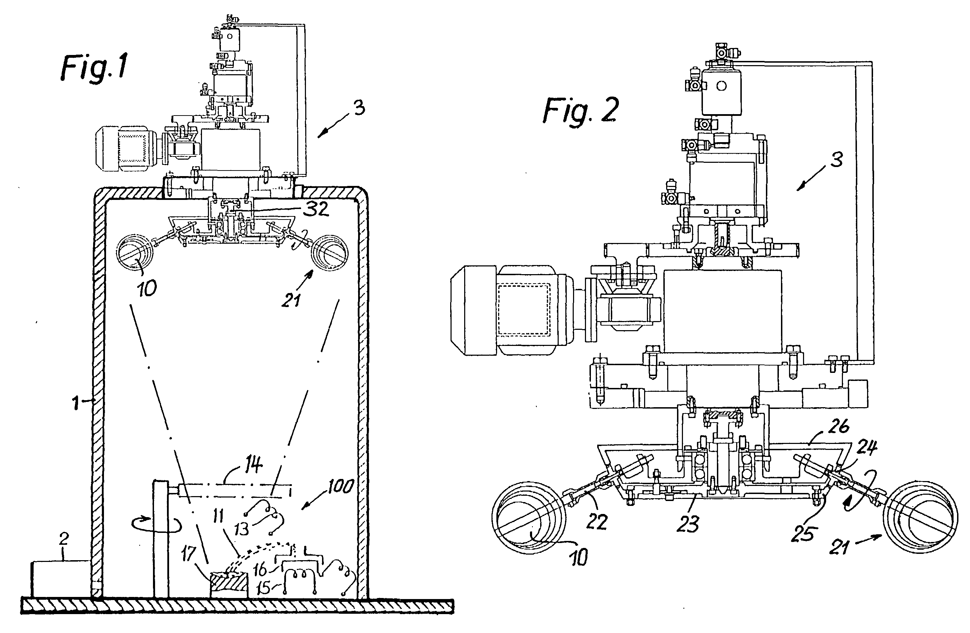

Die in Fig. 1 beispielsweise veranschaulichte Vakuum-Beschichtungsanlage zum Aufdampfen von Vergütungsschichten auf optische Substrate, beispielsweise hier Kunststoff-Brillenglaser 10, umfasst einen, über eine Vakuum-Pumpe 2 evakuierbaren Rezipienten 1.

Im oberen Kammerbereich dieses Rezipienten 1 befindet sich die erfindungsgemässe Wendeträger-Vorrichtung 3 mit einer Mehrzahl, hier zwei erkennbare radial um eine kreisförmige Trägerplatte 23 angeordnete Wendeträger 21, die je an einer, temporär um 180° verdrehbaren Drehachse 22 abgestützt sind, wobei jeder Wendeträger 21 Mittel zum klemmenden Festhalten eines beidseitig zu beschichtenden Substrates oder zum Festhalten von zwei einseitig zu beschichtenden Substraten umfasst (nicht gezeigt).

Die erfindungsgemässe Wendeträger-Vorrichtung 3 wird nachfolgend noch näher beschrieben.

Im unteren Bereich des Rezipienten 1 ist eine Verdampfungsquelle 100 angedeutet, die hier eine sogenannte Elektronenstrahlkanone mit einem Heizfaden 15 umfasst, dessen austretende Elektronen nach seiner Erhitzung in einer Fokussierungseinrichtung 16 strahlenförmig gebündelt werden. Beispielsweise kann der Elektronenstrahl von einer an negativer Hochspannung liegenden Wolframkathode erzeugt und mit einem geformten Wehnelt-Zylinder vorfokussiert werden. Dieser Elektronenstrahl lässt sich nun durch Umlenkmagnetmittel 13 in einen Tiegel 17 umlenken, in dem sich das Aufdampfmaterial befindet.

Zum Betreiben bzw. Bedienen der im evakuierten Rezipienten 1 zu bewegenden Apparateteile, wie etwa die Blende 14 u. dgl., sind Einrichtungen mit Betätigungsbauteilen notwendig, die von aussen in den Vakuumraum hineinreichen (nicht gezeigt). Da der Aufbau und die Funktionsweise solcher Vakuumaufdampfanlagen weiters soweit bekannt sind, erübrigt sich eine nähere Konstruktionsbeschreibung.

Erfindungswesentlich ist hier zunächst, dass die Wendeträger-Vorrichtung 3, wie Fig. 2 erkennen lässt, eine Mehrzahl, radial um die kreisförmige Trägerplatte 23 angeordnete Wendeträger 21 umfasst, die je an einer, temporär um 180° verdrehbaren Drehachse 22 abgestützt sind, wobei jeder Wendeträger 21 Mittel zum klemmenden Festhalten eines beidseitig zu beschichtenden Substrates oder zum Festhalten von zwei einseitig zu beschichtenden Substraten umfasst und wobei an den Wendeträgern 21 resp. Drehachsen 22 Wendemittel zum gleichzeitigen Wenden aller Wendeträger angreifen.

Hierbei umfassen die Wendemittel einen von der Trägerplatte 23 umfänglich abragenden Zahnkranz 25, in den je ein Mitnahmezahnrad 24 eingreift, das mit der Drehachse 22 der Wendeträger 21 sowie mit einem weiteren, temporär verdrehbaren Gegenzahnkranz 26 in Wirkungsverbindung steht.

Damit ist es möglich, zu geeigneter Zeit den Gegenzahnkranz 26 relativ zum Zahnkranz 25 soweit zu verdrehen, bis die Wendeträger 21 mit ihren Substraten über das jeweilige Mitnahmezahnrad 24 um 180° gedreht sind. Dies erfolgt in Bruchteilen einer Sekunde, also so schnell, dass der Bedampfungsstrahl nicht unterbrochen werden muss.

Aus dem Vorbeschriebenen ergibt sich somit eine Vakuum-Beschichtungsanlage zum Aufdampfen von vielfachen Vergütungsschichten auf optische Substrate, die allen heutigen Anforderungen an solche Einrichtungen zu genügen vermag.

Natürlich sind an der vorbeschriebenen Anlage eine ganze Reihe Modifikationen möglich, ohne dabei den Erfindungsgedanken zu verlassen. Dies bezieht sich sowohl auf die Ausgestaltung der Wendemittel als auch auf die Wendeträger resp. deren Mittel zum klemmenden Festhalten der Substrate. Ferner ist es auf viele Arten möglich, die Wirkungsverbindungen hydraulisch oder pneumatisch herzustellen und dies über eine Computersteuerung anzusteuern.

Es wird Schutz beansprucht wie folgt:

## Patentansprüche

1. Vakuum-Beschichtungsanlage zum Aufdampfen von Vergütungsschichten auf Flächen optischer Substrate, wie Kunststoff-Brillengläser, welche auf Trägermit-tel aufspannbar sind, die sich in einem evakuierbaren Rezipienten im Strahlungsbereich mindestens einer Verdampfungsquelle befinden, wobei die Trägermittel von einer Wendeträger-Vorrichtung gebildet sind, mit einer Mehrzahl, radial um eine kreisförmige Trägerplatte angeordnete Wendeträger, die je an einer, temporär um 180° verdrehbaren Drehachse abgestützt sind und je Mittel zum klemmenden Festhalten eines beidseitig zu beschichtenden Substrates oder zum Festhalten von zwei einseitig zu beschichtenden Substraten umfassen und wobei an den Drehachsen Wendemittel zum gleichzeitigen Wenden aller Wendeträger angreifen,
dadurch gekennzeichnet,
dass die Wendemittel einen von der Trägerplatte (23) umfänglich abragenden Zahnkranz (25) umfassen, in den je ein Mitnahmezahnrad (24) auf je einer der Drehachsen (22) der Wendeträger (21) eingreift, welche Mitnahmezahnräder gleichzeitig in einen weiteren, temporär von den äusseren motorischen Antriebsmitteln der Wendeträger-Vorrichtung (3) antreibbaren, verdrehbaren Gegenzahnkranz (26) eingreifen, zu deren gleichzeitigen raschen Verdrehung um 180° bei einer Verdrehung des Gegenzahnkranz (26) relativ zum Zahnkranz (25).

## Claims

1. Vapor deposition apparatus for coating optical substrates, such as plastic spectacle lenses, which can be clamped onto carrier means that are located either above or below replaceable evaporation sources in a container that can be evacuated, wherein the carrier means are formed by a reversible carrier device, with a plurality of reversible carriers arranged radially around a circular carrier plate, which are respectively supported an a rotational axis that can be rotated temporarily by 180°, and comprises means for a clamped holding of a substrate to be coated an both sides or for holding two substrates to be coated an one side each, and wherein reversing means for the simultaneous turning of all reversible carriers act upon the rotational axes,
characterized in that
the reversing means comprise a ring gear (25) that projects around the circumference from the carrier plate (23) and meshes with one each driving gear (24) and is operationally connected to the rotational axis (22) for the reversible carriers (21) as well as with a temporarily rotatable counter ring gear (26) which is turned externally by the motor driving means of the reversible carrier device (3) to be rotated the reversible carriers (21) temporarily by 180° within fractions of a second by turning the counter ring gear (26) relative to the ring gear (25).

## Revendications

1. Installation de dépôt sous vide en phase vapeur pour déposer en phase vapeur des couches antireflets sur des faces de substrats optiques, comme des verres de lunettes en matière synthétique, qui peuvent être tendus sur des moyens de support qui se trouvent dans un récipient apte à être évacué dans la zone de rayonnement d'au moins une source de vaporisation, où les moyens de support sont formés par un dispositif de supports de retournement, avec une multitude de supports de retournement disposés radialement autour d'une plaque de support circulaire qui prennent appui chacun sur un axe de rotation apte à tourner temporairement sur 180° et qui comportent chacun des moyens pour la retenue avec serrage d'un substrat à revêtir des deux côtés ou pour retenir deux substrats à revêtir d'un côté et où s'appliquent aux axes de rotation des moyens de retournement pour retourner en même temps tous les supports de retournement,
caractérisée en ce que les moyens de retournement comprennent une couronne dentée (25) faisant saillie du pourtour de la plaque de support (23), dans laquelle s'engage respectivement une roue dentée d'entraînement (24) sur respectivement l'un des axes de rotation (22) des supports de retournement (21), où les roues dentées d'entraînement s'engagent en même temps dans une contre-couronne dentée (26) tournante supplémentaire, apte à être entraînée temporairement par les moyens d'entraînement moteurs extérieurs du dispositif de supports de retournement (3), en vue de leur rotation simultanée rapide sur 180° lors d'une rotation de la contre-couronne dentée (26) relativement à la couronne dentée (25).
